Europäisches Patentamt

European Patent Office

Office européen des brevets

(11) Publication number: **0 089 387**
A1

# (12) EUROPEAN PATENT APPLICATION

(21) Application number: **82102254.8**

(22) Date of filing: **19.03.82**

(51) Int. Cl.³: **B 32 B 15/08**
**B 32 B 31/20, H 05 K 3/02**

(43) Date of publication of application:
28.09.83 Bulletin 83/39

(84) Designated Contracting States:
BE DE FR GB NL SE

(71) Applicant: **UOP Inc.**
**10 UOP Plaza Algonquin & Mt. Prospect Roads**
**Des Plaines Illinois 60016(US)**

(72) Inventor: **Naegle, Peter Joseph**
**419 Oak Avenue**
**South Onalaska Wisconsin, 54650(US)**

(74) Representative: **Weber, Dieter, Dr. et al,**
**Dr. Dieter Weber und Klaus Seiffert Patentanwälte**
**Gustav-Freytag-Strasse 25**
**D-6200 Wiesbaden 1(DE)**

(54) Preparation of copper-clad laminates.

(57) Copper-clad laminates which may be utilized as circuit boards for electronic equipment may be prepared by forming a composite consisting of at least one sheet of a high profile copper and one sheet of a thermoplastic resin which has a glass transition temperature above about 170° C and thereafter subjecting the composite to an elevated pressure at a temperature in excess of the glass transition temperature of the resin to directly bond the resin to the copper. The copper-clad laminate will possess excellent characteristics of peel strength and solder dip resistance.

EP 0 089 387 A1

Croydon Printing Company Ltd

# Background of the Invention

With the advent of various electronic apparatus, the use of circuit boards for these apparatus has increased to a great degree over the past few years. The circuit boards, which comprise a metal bonded to a support which may be synthetic or naturally occuring in nature such as plastic paper, woven material, etc., have been prepared by bonding the metal to the support by either an additive process or by the addition of an adhesive film whereby the metal is bonded to the support by the adhesive action of the film.

One method of effecting the additive process of the metal to the support is by utilizing an additive reduction/oxidation deposition of metal in total or the same additive deposition followed by an electrolytic process in which the metal such as copper is then electroplated on the additively deposited metal on the surface of the support in an electrolytic bath. The electrolytic method of depositing the metal on the surface of the support utilizes, of necessity, metal electrodes and an electrolyte. The thickness of the metal deposit on the support must be rapidly controlled by various factors such as time, temperature, electrolyte strength, etc. In many instances, a disadvantage of this process is that it is difficult to obtain a uniform deposition of the metal consistency over a relatively long period of time. Also, the bond strength of additively deposited metal on polymer surfaces has in most part not been equal to other techniques of metal cladding. Likewise, when using an adhesive film to bond the metal to the surface of the support, it is necessary to use relatively precise conditions. For example, when using an epoxy adhesive film in the pre-preg or B-stage between the metal and the polysulfone, the pressure which is used must be controlled within a relatively narrow range. This is due to the fact that if too high a pressure is used, there will be a tendency to crack the polymeric support. One prior patent, namely U.S. Patent No. 3,939,024, describes a method whereby the metallic sheets which comprise one portion of the metal-clad laminate are cleaned and primed with an adhesive, either thermoplastic or thermoset in nature, and therefore laminated under heat and pressure into the thermoplastic support.

The patent goes on to say that if a thermoset adhesive is used, it is precured on the metal. Conversely, if the thermoplastic material itself is tacky, it is not necessary to utilize an adhesive. However, this limits the type of thermoplastic support which may be employed.

U.S. Patent No. 3,146,146 describes a method for increasing the strength of the bond of polymer-metal laminates in which the bond between the metal and support is improved by irradiation the support, while in a molten state and in contact with the metal to which it is to be bonded, with high energy ionizing radiation, examples of this irradiation being gamma rays, alpha particles, electrons and protons. U.S. Patent No. 3,932,250 teaches a method for preparing a metal foil or plastic film-overlayed laminate using, as the support or laminate, resin impregnated glass fabrics, glass mats, glass papers, glass-cellulose papers, cellulosic papers as well as synthetic and natural fiber fabrics. The clad laminate is sealed along the edges by placing the metal or plastic film and the laminate between two pressed blades, said pressed blades being covered with a glossy aluminum foil which is used as a release film and by a dissimilar metal such as copper on the other side. Another prior U.S. Patent, namely Patent No. 3,514,308 discloses a method for bonding polyolefins to metallic substrates in which the solid polymer and metal are contacted in an oxygen-containing atmosphere at a temperature to substantially complete the melting of the polyolefin at the interface. However, this patent appears to require the presence of an oxygen-containing atmosphere to effect the desired reaction. In a similar manner, U.S. Patent No. 3,274,328 discloses a process for preparing a dielectric for circuit boards and strip lines in which the dielectric material or substrate comprises a blend of two polymers, namely polystyrene and polyethylene. The circuit board which results from the treatment of cladding of this substrate with copper processes certain characteristics including a solder dip resistance of 45 seconds at 450° F (232° C). As will hereinafter be shown in greater detail, it has now been discovered that copper may be directly bonded to a solid polymetallic support which possesses a glass transition temperature of at least 170° C at a low pressure and has a relatively short cycle to form a copper-clad laminate which possesses desirable characteristics and which may be utilized for any functions for which the prior art composites are not suitable due to lack of the aforesaid characteristicts.

Brief Summary of the Invention

This invention relates to a process for preparing metalclad laminates. More specifically, the invention is concerned with a process for obtaining a direct bond between high profile copper and a thermoplastic resin which possesses certain characteristics, utilizing relatively mild operating conditions of time, temperature, and pressure. Copper-clad laminates in which the metallic portion of the laminate may be on either one or both sides of the finished product may be used in the preparation of circuit boards. The circuit boards which are obtained by this process are used in various electronic equipment and are particularly adapted for use in equipment which involves relatively high frequency. For example, the circuit boards which are prepared according to the process of this invention may be used in microwave equipment such as radars, altimeters, distance measuring equipment and in high speed digital equipment such as computers where the frequency is measured in gigahertz or gigabits (giga is $10^9$).

It is therefore an object of this invention to provide a process for preparing copper-clad laminates.

A further object of this invention is to provide a process for the direct bonding of supports such as thermoplastic resins to conductive metals.

In one aspect, an embodiment of this invention resides in a process for the preparation of a high profile copper-clad laminate which comprises forming a composite consisting of at least one sheet of said copper and a sheet of a thermoplastic resin which possesses a glass transition temperature of at least 170° C, subjecting said composite to an elevated pressure at a temperature in the range of from about 170° to about 300° C for a period of time sufficient to directly bond said copper to said resin, and recovering the resultant high profile copper-clad laminate which possesses a peel strength in excess of about 6.5 lbs. per inch.

A specific embodiment of this invention is found in a process for the preparation of a high profile copper-clad laminate which comprises forming a composite consisting of at least one sheet of a high profile copper and a sheet of polysulfone, subjecting said composite to an elevated pressure in the range of from about 75 to about 350 lbs. per square inch at a temperature in the range of from about 170° to about 300° C for a period of time seen by the bondlines in question ranging from about 10 seconds to about 20 minutes, and recovering the resultant high profile copper-clad polysulfone which possesses a peel strength in excess of about 6.5 lbs. per inch.

Other objects and embodiments may be found in the following further detailed description of the invention.

Detailed Description of the Invention

The present invention is concerned with a process for the preparation of copper-clad laminates and, more specifically, to a process wherein the support, which comprises a thermoplastic resin of the type hereinafter set forth in greater detail, is directly bonded to a high profile copper portion of the laminate. The resulting copper-clad laminate will possess desirable characteristics which will enable the laminate to be used for a variety of purposes. The term, "high profile copper," as used in the present specification and appendant claims, will be defined as a copper foil or sheet which is smooth on one side and rough on the other side. The roughness of the one side of the copper foil or sheet will comprise modules which are more dense and/or longer in size than those which will be found on copper foil or sheets which have been treated in a conventional manner. The normal copper foil which is not of the high profile type will not achieve the peel strength which is afforded by the copper-clad laminates which are prepared according to the process of this invention. Likewise, the copper-clad laminate which is prepared according to the process of the present invention will also possess a solder dip resistance which is greater than that which is possessed by the laminate prepared in a conventional manner. For example, the solder dip resistance of the laminate of the present invention will be of at least 45 seconds at a temperature of at least 250° C. This is in contrast with the solder resistance of the metal-clad laminate which is shown in U.S. Patent No. 3,274,328 which discloses a solder resistance of 45 seconds at 232° C. The ability to resist a solder dip for a period of 45 seconds at 260° C is advantageous inasmuch as a more complete solder is attained at higher temperatures.

The direct bonding of the thermoplastic resin to the copper portion of the laminate is effected by forming a composite in which the sheet of thermoplastic resin which possesses a glass transition temperature of at least 170° C and which has a predetermined thickness acts as a support in contact with at least one sheet of copper. Thereafter, the composite is subjected to an elevated pressure at a temperature in excess of that of the glass transition temperature of the resin for a predetermined period of time. The thermoplastic resin will be directly bonded to the copper, thus eliminating the need for an adhesive film to effect a bond between the support and the copper. Operating parameters which are employed in the process of this invention will include a pressure in the range of from about 75 to about 350 lbs. per sq. in. (psi), a temperature which, as hereinbefore set forth, will depend upon the glass transition temperature of the particular thermoplastic resin which is employed, and will usually be in the range of from about 170 to about 300° C, as well as a time cycle which may range at the bondline of interest from about 10 seconds to about 20 minutes in duration.

As hereinbefore set forth, the conductive metal which forms one component of the laminate of the present invention will comprise a high profile copper which may range in thickness from about 0.125 oz. (5 micron) up to about 4 oz. (0.0056 in.) or more. Examples of thermoplastic resins which form the second component of the laminate of the present invention will comprise those which possess a glass transition temperature of at least 170° C and will include those resins such as acetals whose crystalline form melting point ranges from 170° To 181° C, cellulosic resins having a crystalline form melting point ranging from 170° to 230° C, fluoroplastic whose crystalline form melting point ranges from 170° to 327° C, nylon-6 having a crystalline form melting point ranging from 216° to 265° C, nylon-11 having a crystalline form melting point of 195° C, nylon-12 having a crystalline form melting point of 175° C, thermoplastic polyesters having a crystalline form melting point in the range of from 232° to 267° C, polyphenylene sulfide having a crystalline form melting point of 290° C, polyamide having an amorphous form melting point of 275° C, polyaryl ester resin having an amorphous form melting point of 190° C, polyimide resin having an amorphous form melting point ranging from 310 to 365° C, polysulfone having an amorphous form melting point ranging from 193° to 230° C, etc. It is to be understood that the aforementioned conductive metals and thermoplastic resins are only representative of the class of compounds which may be employed and that the present invention is not necessarily limited thereto.

The desired copper-clad laminates in which the thermoplastic resin is directly bonded to the copper portion of the laminate may be prepared in either a batch or continuous-type operation. For example, when a batch-type operation is employed, the composites are formed by placing a sheet of the thermoplastic resin support on a sheet of copper or between two sheets of copper in the event that a lamiante containing copper on each side of the aforesaid laminate is desired. In the event that the finished laminate will contain a copper sheet on each side thereof, it is possible to form these laminates either alone or by placing several composites together. In the preferred embodiment of the invention a number of laminates from 1 to about 20, depending on the dielectric thickness, can be formed from these composites by placing one composite on top of another. In a simplification of the laminating apparatus, it is unnecessary that caul plates to be placed between the laminates, only a top and bottom caul plate being required. If so desired, the thermoplastic resin sheets and copper sheets can be dried at an elevated temperature in an air circulating oven for a period of time sufficient to drive off any moisture which may be present on or in the sheets. After placing the composites in the desired position, they are then subjected to an elevated pressure within the range hereinbefore set forth for a predetermined period of time. The temperature at which the formation of the desired laminates is effected will, as hereinbefore set forth, be dependent upon the melt temperature of the particular thermoplastic resin which is employed as the support member of the laminate. After subjecting the composites to the desired temperature and pressure for the proper time, the temperature is dropped to about 50° C while maintaining the pressure level. The laminates are then removed from the press by relieving the pressure.

It is also contemplated within the scope of this invention that the desired copper-clad laminate may be prepared in a continuous manner of operation. One such method of effecting the desired preparation is to continuously feed sheets of copper containing a thermoplastic resin filler to an apparatus wherein the sheets are placed under the desired pressure while maintaining the apparatus at a temperature in excess of that of the melt temperature of the thermoplastic resin. The passage of the composite or laminate through the apparatus will be regulated in such a manner so that the desired period of time will take place and, after passage through the apparatus for this predetermined period of time, the thus formed copper-clad laminate in sheet form will be continuously withdrawn, passed through a cooling zone, and thereafter recovered.

The following examples are given for purposes of illustrating the process of this invention. However, it is to be understood that these examples are given merely for purposes of illustration and that the present process is not necessarily limited thereto.

Example 1

A copper-clad laminate was prepared by prebaking sheets of high profile copper and polysulfone in an air circulating oven for a period of 2 hours at a temperature in the range of from about 90° C to about 105° C for a period of 2 hours to drive off any moisture which was present. Following this, a sheet of copper was placed on a stainless steel caul plate and a sheet of the polysulfone was placed on top of the copper. Thereafter, another sheet of copper was placed on top of the polysulfone to form a composite comprising a sheet of copper on each side of the sheet of polysulfone. Six more composites similar in nature to this were made, one composite being placed on top of another composite. There were no caul plates placed between the composites. A second stainless steel caul plate was placed on top of the composites and the composites were then placed in a hot press maintaining at a temperature of 232° C under a pressure of 125 psi. The composites were maintained in the hot press for a period of from 30 seconds to 3 minutes at the bondlines of interest, during this time the polysulfone melting and forming a direct bond to the two copper sheets on each side thereof. At the end of this time, the copper-clad laminates thus formed were cooled to a temperature of about 50° C by means of circulated cooling water followed by removal of pressure and extraction from the press.

The thus formed laminates were subjected to various physical tests with the following results.

| Test | Results |
|---|---|
| Peel strength (lb/in; 1 oz of Cu) | 8.5-9.0 avg. |
| Coefficient of linear expansion (in/in/°C) (Z-direction) | $4.5 \times 10^{-5}$ |
| Glass transition temperature (°C) | 192 |
| Water absorption (%) | 0.29 |
| Solder blister (20 sec. at 260° C) | Pass |

In addition to the various physical tests, the laminates were also subjected to tests to obtain electrical data for said laminates. The GHz dielectric measurements made by MIT were made in the 1-24 GHz range using the standing wave method in a shorted coaxial line. The measuring instrument was a Central Research Laboratories Microwave Dielectrometer, a one inch coax line with probe displacements measured to the micron. For the temperature run, each conductor was provided with a separate heater. The change in length of the sample was monitored with a depth gage. The general technique is discussed in <u>Dielectrics and Waves</u> and in <u>Dielectric Materials and Applications</u>, both edited by A. van Hippel, ASTM D 2520-70. Calculation procedures are discussed in "Computer Program for Calculating Dielectric Properties of Low- or High-Loss Materials from Short-Circuited Waveguide Measurements." by S.O. Nelson, C.W. Schlaphoff, and L.E. Stetson, Agricultural Research Service, U.S. Department of Agriculture, ARS-NC-4, Nov. 1972. The results from this test in which the frequency ranged from 1 to 24 gigahertz and the temperature ranged from 23° C up to 175° C and back down to 23° C are set forth in the table below in which K represents the dielectric constant and Z represents the dissipation factor.

TABLE

Freq., GHz

| Temp. °C. | | 1 | 2.45 | 3 | 5 | 8.5 | 14 | 24 |
|---|---|---|---|---|---|---|---|---|
| 23 | K | 2.981 | 2.978 | 2.977 | 2.975 | 2.960 | 2.950 | 2.945 |
|  | Z | .00893 | .00459 | .00469 | .00524 | .00539 | .00560 | .00573 |
| 50 | K | 2.983 | 2.976 | 2.975 | 2.973 | 2.954 | 2.946 | 2.940 |
|  | Z | .00412 | .00484 | .00523 | .00568 | .00595 | .00623 | .00669 |
| 100 | K | 2.984 | 2.982 | 2.980 | 2.976 | 2.953 | 2.945 | 2.940 |
|  | Z | .00458 | .00548 | .00585 | .00634 | .00704 | .00734 | .00760 |
| 150 | K | 2.965 | 2.963 | 2.961 | 2.958 | 2.948 | 2.943 | 2.935 |
|  | Z | .00428 | .00552 | .00603 | .00664 | .00766 | .00812 | .00877 |
| 175 | K | 2.948 | 2.946 | 2.945 | 2.941 | 2.934 | 2.928 | 2.921 |
|  | Z | .00370 | .00500 | .00546 | .00623 | .00762 | .00872 | .00968 |
| 150 | K | 2.952 | 2.952 | 2.951 | 2.950 | 2.946 | 2.940 | 2.934 |
|  | Z | .00362 | .00474 | .00526 | .00594 | .00695 | .00725 | .00784 |
| 100 | K | 2.953 | 2.952 | 2.951 | 2.949 | 2.942 | 2.936 | 2.931 |
|  | Z | .00357 | .00458 | .00489 | .00547 | .00629 | .00660 | .00680 |
| 50 | K | 2.959 | 2.957 | 2.957 | 2.955 | 2.940 | 2.935 | 2.928 |
|  | Z | .00352 | .00431 | .00456 | .00501 | .00562 | .00570 | .00574 |
| 23 | K | 2.959 | 2.958 | 2.956 | 2.954 | 2.937 | 2.935 | 2.930 |
|  | Z | .00321 | .00408 | .00419 | .00467 | .00524 | .00518 | .00510 |

0089387

It will be noted from the above table that the direct bonding laminates which were prepared according to the process of this invention provide electric data in which the dielectric constant and the dissipation factor remain fairly uniform over a wide range of temperatures and frequencies, thus permitting for use in equipment involving high frequencies.

Example II

Other laminates may be prepared by forming a composite comprising a support of polyphenylsulfide, polyamide or polyimide sandwiched between two sheets of high profile copper and subjected to an elevated pressure of about 150 psi at temperatures of about 295° C, 280° C, and 315° C respectively to form laminates in which the support may be directly bonded to the copper sheets.

I claim as my Invention:

1. A process for the preparation of a high profile copper-clad laminate which comprises forming a composite consisting of at least one sheet of said copper and a sheet of a thermoplastic resin which possesses a glass transition temperature of at least 170° C, subjecting said composite to an elevated pressure at a temperature in the range of from about 170° to about 300° C for a period of time sufficient to directly bond said copper to said resin, and recovering the resultant high profile copper-clad laminate which possesses a peel strength in excess of about 6.5 lbs. per inch.

2. The process as set forth in Claim 1 in which said elevated pressure is in a range of from about 75 to about 350 lbs. per sq. inch.

3. The process as set forth in Claim 1 in which said bonding time is in a range of from about 10 seconds to about 20 minutes.

4. The process as set forth in Claim 1 in which said high profile copper-clad laminate possesses a solder dip resistance of at least 45 seconds at 260° C.

5. The process as set forth in Claim 1 in which said thermoplastic resin is polysulfone.

6. The process as set forth in Claim 1 in which said thermoplastic resin is polyphenylenesulfide.

7. The process as set forth in Claim 1 in which said thermoplastic resin is polyamide.

8. The process as set forth in Claim 1 in which said thermoplastic resin is polyimide.

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| | --- | | B 32 B 15/08 |
| Y | GB-A- 974 227 (SANDERS)<br>* Claims 1,6; page 2, lines 15-120; page 4; page 5, lines 1-25 * | 1-3,7 | B 32 B 31/20<br>H 05 K 3/02 |
| | --- | | |
| Y | US-A-3 809 591 (E.A. VOGELFANGER)<br>* Claims 1-5,7,12,13; column 5, line 57 - column 6, line 49; example 1 * | 1,2,7 | |
| | --- | | |
| A | GB-A-1 120 575 (DYNAMIT NOBEL)<br>* Claims 1,7-9,14; page 2, lines 25-60; examples 1,4 * | 1,3,7 | |
| | --- | | |
| A,D | US-A-3 939 024 (J.T. HOGGATT)<br><br>* Claim 1; column 3, line 16 - column 4, line 14; figure 2 * | 1,5,7,8 | **TECHNICAL FIELDS SEARCHED (Int. Cl. ³)** |
| | --- | | |
| A | GB-A-1 240 665 (M.M.M.)<br>* Claims 1,2,8-11,17; page 2, line 90 - page 3, line 71; examples 1,3 * | 1,7 | B 32 B |
| | ----- | | |

The present search report has been drawn up for all claims

| Place of search | Date of completion of the search | Examiner |
|---|---|---|
| THE HAGUE | 19-11-1982 | BLASBAND I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82